# EUROPÄISCHE PATENTSCHRIFT

(11) **EP 0 784 099 B1**
(45) Veröffentlichungstag und Bekanntmachung des Hinweises auf die Patenterteilung: **13.11.2002**
(21) Anmeldenummer: 97100093.0
(22) Anmeldetag: 04.01.1997
(51) Int. Cl.: C22C 9/00, H01L 23/495

(54) **Kupfer-Chrom-Titan-Silizium-Legierung und ihre Verwendung**
Copper-chromium-titanium-silicon alloy and its use
Alliage cuivre-chrome-titane-silicium et son utilisation

(30) Priorität: 12.01.1996 DE 19600864
(43) Veröffentlichungstag der Anmeldung: 16.07.1997
(73) Patentinhaber: WIELAND-WERKE AG, 89079 Ulm (DE)
(72) Erfinder: Bögel, Andreas, Dipl.-Ing.-Dr.-rer.-nat., 89264 Weissenhorn (DE); Bohsmann, Michael, Dipl.-Ing.-Dr.-rer.-nat., 89081 Ulm (DE)

(56) Entgegenhaltungen:
- DE-A- 3 812 563
- DE-C- 3 527 341

## Beschreibung

Die Erfindung betrifft eine Kupfer-Chrom-Titan-Silizium-Legierung nach dem Oberbegriff des Anspruchs 1 und ihre Verwendung.

Es besteht ein großer Bedarf an Kupferlegierungen für elektrische Anwendungszwecke. Diese Legierungen werden u. a. benötigt als Werkstoffe für elektronische Bauteile, insbes. Halbleiterträger (sogenannte lead frames) für Transistoren, integrierte Schaltungen od. dgl., für Steckverbinder, Relais, elektrische Bauteile wie z. B. Sicherungshalter, Kontaktfedern o. ä. und Teile für die Autoelektrik.

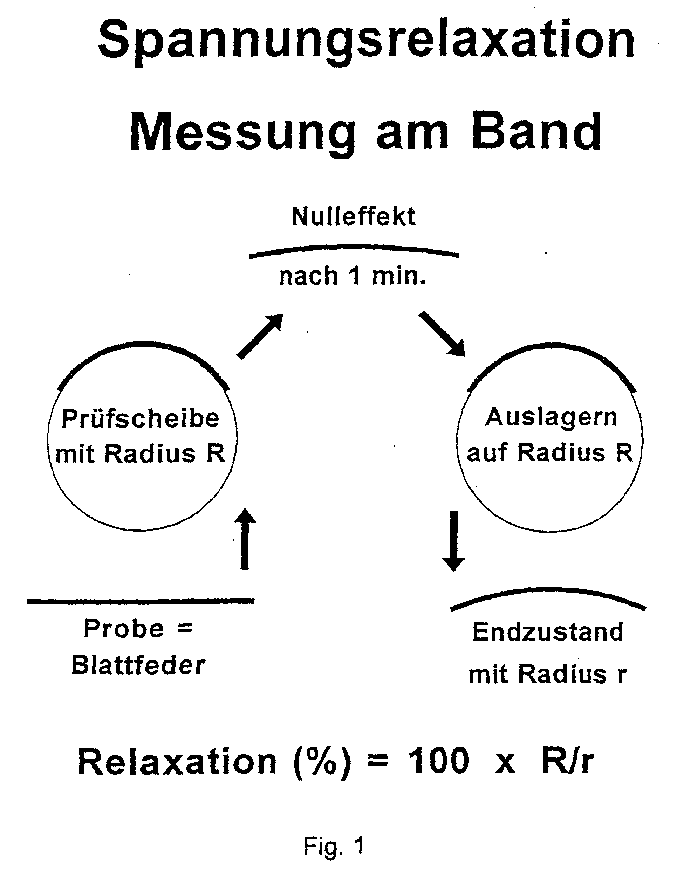

Werkstoffe für die genannten Anwendungszwecke müssen besondere Eigenschaftskombinationen aufweisen:
a) die elektrische und thermische Leitfähigkeit sollte möglichst hoch sein (etwa oberhalb 50 % IACS) ;
b) es wird eine hohe mechanische Festigkeit bei gleichzeitig ausreichender Biegbarkeit gefordert;
c) es wird darüber hinaus eine hohe Erweichungsbeständigkeit gefordert;
d) wegen der zunehmenden Miniaturisierung werden in zunehmendem Maße Werkstoffe gefordert, deren Gefüge keine groben Ausscheidungen oder Einschlüsse enthält;
e) insbesondere für Steckverbinder und elektrische Bauteile ist eine gute Beständigkeit gegen Spannungsrelaxation erforderlich (zum Begriff der "Spannungsrelaxation" vgl. insbes. den Aufsatz "Spannungsrelaxation in Kupferlegierungen für Steckverbinder und Federelemente" von A.Bögel in der Zeitschrift "Metall", 48. Jahrgang, Nr. 11/94, S.872 bis 876; zum Meßverfahren s. Fig.1).

Für die genannten Anwendungsfälle werden bisher in großem Umfang u. a. Eisen-Nickel-Legierungen oder Kupferlegierungen, wie beispielsweise CuFe2P (C 19400) oder CuNi3Si1Mg (C 7025) sowie CuCrTiSi (C 18090) eingesetzt. Auch bei den genannten Kupferlegierungen lassen die Relaxationsbeständigkeit bis 130 °C oder die elektrische Leitfähigkeit oder teilweise auch die Homogenität der Werkstoffe zu wünschen übrig.

Die genannten Forderungen sind bisher weitgehend von einer Kupfer-Chrom-Titan-Silizium-Legierung mit 0,10 bis 0,50 % Chrom; 0,01 bis 0,25 % Titan; 0,01 bis 0,10 % Silizium; Rest Kupfer und üblichen Verunreinigungen nach der US-PS 4.678.637 erfüllt worden. Bereits dort konnte ein sehr gutes Eigenschaftsprofil - hohe elektrische Leitfähigkeit bei gleichzeitig hoher Festigkeit und guter Biegbarkeit - erzielt werden, jedoch zeigt sich, daß die Relaxationsbeständigkeit bei Temperaturen unter 130 °C noch zu gering ist.

Der Erfindung liegt daher die Aufgabe zugrunde, eine Kupferlegierung der genannten Art anzugeben, welche bedeutend geringere Relaxation bis 130 °C bei gleichzeitig entsprechend hoher elektrischer Leitfähigkeit und Festigkeit aufweist.

Die Aufgabe wird erfindungsgemäß durch eine Kupferlegierung der genannten Art gelöst, die dadurch gekennzeichnet ist, daß sie zusätzlich 0,02 bis 0,8 % Magnesium enthält (die Prozentangaben beziehen sich dabei auf das Gewicht). Die vorteilhaften Eigenschaften der erfindungsgemäßen Legierung werden weiter unten anhand eines Ausführungsbeispiels näher erläutert.

Insbes. gegenüber der JP-OS 63-125.628 liegt eine Auswahlerfindung vor, da die drei erforderlichen Kriterien erfüllt sind:
Die Überschneidung der einzelnen Parameterbereiche ist eng. Zudem fehlen in der JP-OS Beispiele für eine Cu-Cr-Ti-Si-Mg-Legierung.
Schließlich liegt auch eine gezielte Auswahl hinsichtlich der Beständigkeit gegen Spannungsrelaxation vor.

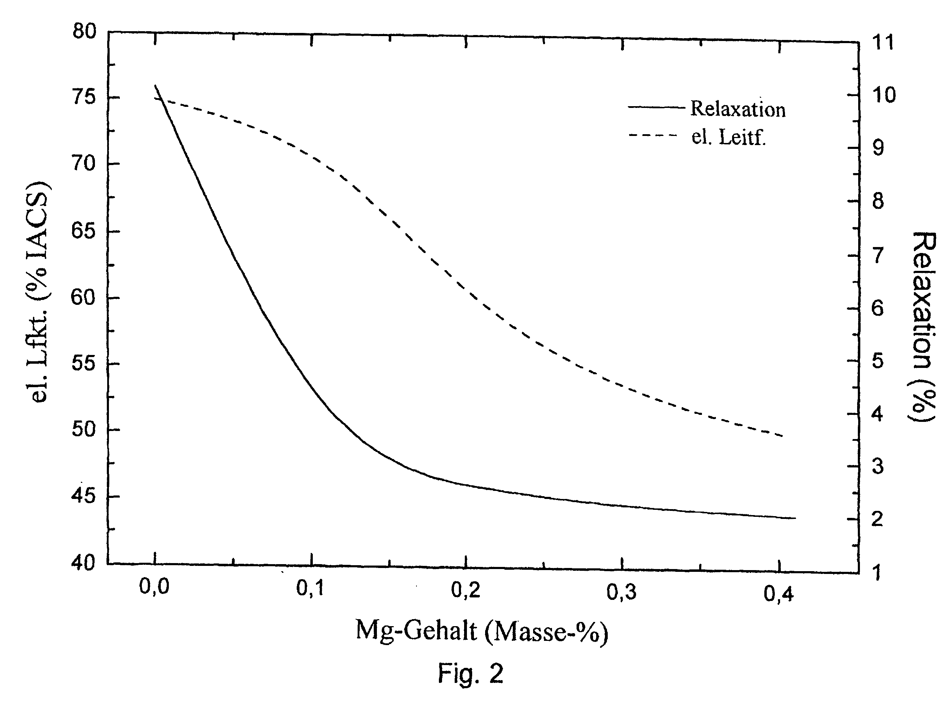

Aus Fig. 2 (welche die Eigenschaften einer CuCr0,3Ti0,06Si0,03-Legierung in Abhängigkeit von der zugesetzten Mg-Menge zeigt) ist ersichtlich, daß die Spannungsrelaxation einer CuCrTiSi-Legierung mit zunehmendem Mg-Gehalt zunächst deutlich abnimmt und bei höheren Gehalten nahezu konstant bleibt, während die elektrische Leitfähigkeit kontinuierlich abnimmt. Ebenso ist ersichtlich, daß der Mg-Gehalt zur Erreichung eins signifikanten Effekts auf die Relaxation mindestens etwa 0,02 % betragen muß.

Da die elektrische Leitfähigkeit mit steigendem Mg-Gehalt stark abnimmt, erscheint eine Legierungszusammensetzung mit mehr als 0,8 % Mg für die genannten Anwendungszwecke nicht geeignet, entsprechend sind die bevorzugten Mg-Gehalte in den Ansprüchen 2 und 3 beschränkt. Weitere bevorzugte Legierungszusammensetzungen ergeben sich aus den Ansprüchen 4 bis 6.

Aufgrund ihrer ausgezeichneten Eigenschaften wird die erfindungsgemäße Legierung als Werkstoff für elektronische Bauteile, insbes. Halbleiterträger für Transistoren, integrierte Schaltungen od. dgl., für Steckverbinder und allgemeine elektrische Bauteile sowie für Teile in der Autoelektrik empfohlen.

Die Erfindung wird anhand des folgenden Ausführungsbeispiels näher erläutert:

Tabelle 1 zeigt die Zusammensetzung dreier erfindungsgemäßer Legierungen (Nr. 1, 2, 3).

**Tabelle 1:**

| Zusammensetzung der Proben (Angaben in Gew.-%) | | | | | | |
|---|---|---|---|---|---|---|
| Probenbezeichnung | Cr | Mg | Ti | Si | Sn | Cu |
| 1 | 0,36 | 0,11 | 0,07 | 0,03 | - | Rest |
| 2 | 0,32 | 0,21 | 0,07 | 0,02 | - | " |
| 3 | 0,31 | 0,11 | 0,06 | 0.02 | 0.10 | " |

Die drei Legierungen wurden hergestellt unter Anwendung der üblichen Schritte: Gießen, Anwärmen, Warmumformen, Abkühlen an Luft, wiederholtes Kaltwalzen und Zwischenglühen.

Dabei wurden die Gußblöcke auf 900 °C erwärmt, warmgewalzt und abgekühlt. Dem Kaltwalzen auf eine Zwischendicke von 4,0 mm folgte eine Glühbehandlung bei 470 °C/1 h. Nach einer Schlußabwalzung an 0,34 mm wurden die Zugfestigkeit, Brinell-Härte HB und die elektrische Leitfähigkeit ermittelt.

Die Eigenschaften der Proben sind in Tabelle 2 zusammengestellt, zusammen mit den entsprechende Werten für Legierungen nach dem Stand der Technik.

Die Werte für die Spannungsrelaxation wurden nach 24 h/125 °C bei einer aufgebrachten Spannung in Höhe der Federbiegegrenze (nach DIN 50151) ermittelt.

**Tabelle 2:**

| Elektrische und mechanische Eigenschaften und Relaxation nach 24 h/125 °C | | | | | |
|---|---|---|---|---|---|
| Probenbezeichnung | UNS-Bezeichnung | Zugfestigkeit (N/mm²) | Brinellhärte HB | elektr. Lfkt. (% IACS) | Relaxation (%) |
| 1 | | 540 | 162 | 70 | 2 |
| 2 | | 540 | 171 | 60 | < 2 |
| 3 | | 520 | 171 | 70 | 5 |
| CuFe2P | C 19400 | 480 | 128 | 65 | 15 |
| CuFeSnP | C 19520 | 540 | 147 | 48 | 28 |
| CuZn30 | C 26000 | 575 | 160 | 26 | 28 |
| CuNi9Sn2 | C 72500 | 540 | 142 | 11 | 4 |
| CuNi18Zn20 | C 76400 | 560 | 152 | 6 | 10 |
| CuCrTiSi | C 18090 | 530 | 152 | 75 | 10 |

Es zeigt sich, daß die erfindungsgemäßen Legierungen bedeutend niedrigere Spannungsrelaxationswerte bei gleicher oder sogar höherer Festigkeit und Leitfähigkeit aufweisen.

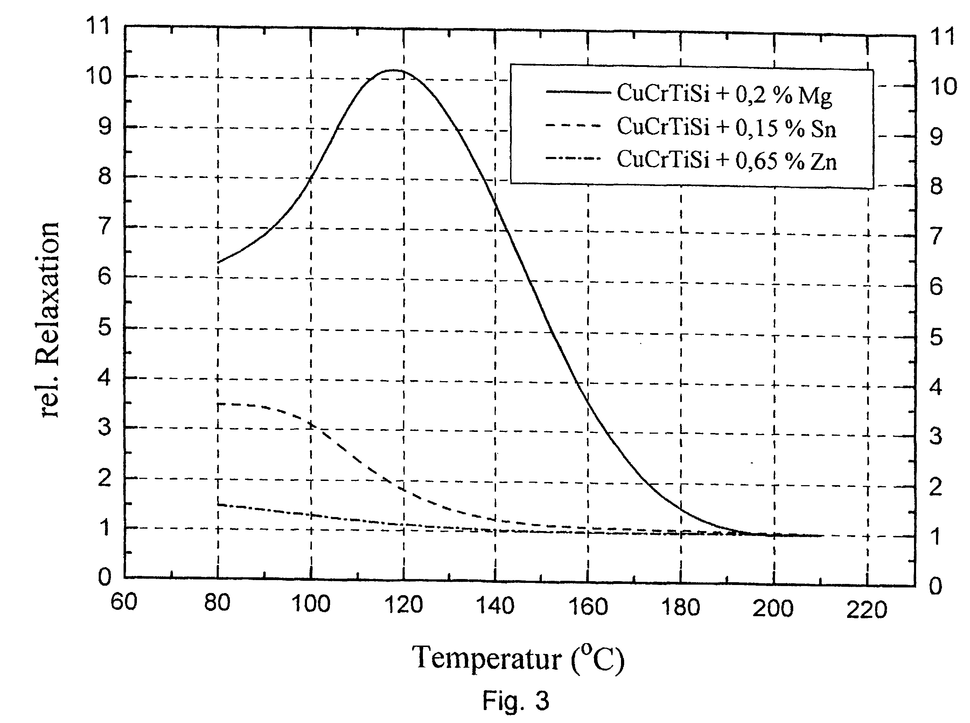

Es zeigt sich, daß die erfindungsgemäßen Legierungen bedeutend niedrigere Spannungsrelaxationswerte bei Temperaturen bis zu 130 °C aufweisen. Oberhalb dieser Temperatur gleichen sie sich denen der bekannten Legierung CuCr0,3Ti0,06Si0,03 an. Zur weiteren Verdeutlichung dieses Zusammenhangs sei auf Fig. 3 verwiesen, in der der Einfluß verschiedener erfindungsgemäßer Legierungszusätze auf das Relaxationsverhalten dargestellt ist, jeweils als Vergleich zu CuCr0,3Ti0,06Si0,03. Bei gleichzeitiger Zugabe mehrerer dieser Elemente überlagern sich die Einzeleffekte.

Bemerkenswerterweise zeigt sich weiterhin, daß durch die zusätzlichen erfindungsgemäßen Legierungselemente die elektrische Leitfähigkeit nicht wesentlich beeinflußt, sogar eine Steigerung der Festigkeit erreicht wird und die günstigen Eigenschaften bei Relaxation oberhalb 130 °C sowie die Erweichungsbeständigkeit und Gleichmäßigkeit des Gefüges in vollem Umfang wie bei C 18090 erhalten bleiben.

Besonders erwähnenswert ist die gute Biegbarkeit der erfindungsgemäßen Legierung, die insbes. für Steckverbinder und Anschlußteile gefordert werden muß. In Verbindung mit der ausgezeichneten Relaxationsbeständigkeit bietet die erfindungsgemäße Legierung wesentliche Vorteile für die genannten Anwendungsgebiete gegenüber der bekannten Legierung C 18090 und den anderen Legierungen nach dem Stand der Technik.

## Patentansprüche

1. Kupfer-Chrom-Titan-Silizium-Legierung, bestehend aus 0,10 bis 0,50 % Chrom; 0,01 bis 0,25 % Titan; 0,01 bis 0,10 % Silizium; Rest Kupfer und üblichen Verunreinigungen,
die
zusätzlich 0,02 bis 0,8 % Magnesium enthält und gegebenenfalls 0.01 bis 1% Zinn und/oder 0.05 bis 2% Zink, wobei das Element Zinn ganz oder teilweise durch das Element Indium ersetzt werden kann.

2. Kupfer-Legierung nach Anspruch 1,
**dadurch gekennzeichnet,**
**daß** der Magnesium-Gehalt 0,05 bis 0,6 % beträgt.

3. Kupfer-Legierung nach Anspruch 1 oder 2,
**dadurch gekennzeichnet,**
**daß** der Magnesium-Gehalt 0,05 bis 0,4 % beträgt.

4. Kupfer-Legierung nach einem oder mehreren der Ansprüche 1 bis 3,
**dadurch gekennzeichnet,**
**daß** sie zusätzlich 0,01 bis 1 % Zinn enthält.

5. Kupfer-Legierung nach Anspruch 4,
**dadurch gekennzeichnet,**
**daß** das Element Zinn ganz oder teilweise durch das Element Indium ersetzt ist.

6. Kupfer-Legierung nach einem oder mehreren der Ansprüche 1 bis 5,
**dadurch gekennzeichnet,**
**daß** sie zusätzlich 0,05 bis 2 % Zink enthält.

7. Verwendung einer Kupfer-Legierung nach einem oder mehreren der Ansprüche 1 bis 6 als Werkstoff für elektronische Bauteile, insbes. Halbleiterträger für Transistoren, integrierte Schaltungen oder dergleichen.

8. Verwendung einer Kupfer-Legierung nach einem oder mehreren der Ansprüche 1 bis 6 als Werkstoff für allgemeine elektrische Bauteile, wie Klemmen, Kontaktschienen, Relais.

9. Verwendung einer Kupfer-Legierung nach einem oder mehreren der Ansprüche 1 bis 6 als Werkstoff für Steckverbinder und federnde Kontakte.

## Claims

1. Copper-chromium-titanium-silicon alloy, comprising from 0.10 to 0.50% of chromium; from 0.01 to 0.25% of titanium; from 0.01 to 0.10% of silicon; remainder copper and usual impurities, which additionally contains from 0.02 to 0.8% of magnesium and optionally from 0.01 to 1% of tin and/or from 0.05 to 2% of zinc, it being possible to replace the element tin entirely or partially by the element indium.

2. Copper alloy according to claim 1, **characterised in that** the magnesium content is from 0.05 to 0.6%.

3. Copper alloy according to claim 1 or 2, **characterised in that** the magnesium content is from 0.05 to 0.4%.

4. Copper alloy according to one or more of claims 1 to 3, **characterised in that** it additionally contains from 0.01 to 1% of tin.

5. Copper alloy according to claim 4, **characterised in that** the element tin is replaced entirely or partially by the element indium.

6. Copper alloy according to one or more of claims 1 to 5, **characterised in that** it additionally contains from 0.05 to 2% of zinc.

7. Use of a copper alloy according to one or more of claims 1 to 6 as a material for electronic components, especially semi-conductor supports for transistors, integrated circuits or the like.

8. Use of a copper alloy according to one or more of claims 1 to 6 as a material for general electrical components, such as terminals, contact bars, relays.

9. Use of a copper alloy according to one or more of claims 1 to 6 as a material for plug-in connectors and resilient contacts.

## Revendications

1. Alliage cuivre-chrome-titane-silicium, constitué de 0,10 à 0,50% de chrome ; 0,01 à 0,25% de titane ; 0,01 à 0,10% de silicium ; le reste de cuivre et d'impuretés habituelles, qui contient en outre 0,02 à 0,8% de magnésium et éventuellement 0,01 à 1% d'étain et/ou 0,05 à 2% de zinc, l'élément étain pouvant être remplacé complètement ou partiellement par l'élément indium.

2. Alliage de cuivre selon la revendication 1, **caractérisé en ce que** la quantité de magnésium atteint 0,05 à 0,6%.

3. Alliage de cuivre selon la revendication 1 ou 2, **caractérisé en ce que** la quantité de magnésium atteint 0,05 à 0,4%.

4. Alliage de cuivre selon l'une ou plusieurs des revendications 1 à 3, **caractérisé en ce qu'**il contient en outre 0,01 à 1% d'étain.

5. Alliage de cuivre selon la revendication 4, **caractérisé en ce que** l'élément étain est remplacé totalement ou partiellement par l'élément indium.

6. Alliage de cuivre selon l'une ou plusieurs des revendications 1 à 5, **caractérisé en ce qu'**il contient en outre 0,05 à 2% de zinc.

7. Utilisation d'un alliage de cuivre selon l'une ou plusieurs des revendications 1 à 6, comme matériau pour des constructions électroniques, en particulier des supports de semi-conducteurs pour des transistors, des circuits intégrés ou autres.

8. Utilisation d'un alliage de cuivre selon l'une ou plusieurs des revendications 1 à 6, comme matériau pour des constructions électriques générales, comme des bornes, des barres de contact, des relais.

9. Utilisation d'un alliage de cuivre selon l'une ou plusieurs des revendications 1 à 6, comme matériau pour des connecteurs et contacts formant ressorts.
